# FASCICULE DE BREVET EUROPEEN

(11) **EP 4 307 706 B1**
(45) Date de publication et mention de la délivrance du brevet: **25.09.2024**
(21) Numéro de dépôt: 23184038.0
(22) Date de dépôt: 07.07.2023
(51) Int. Cl.: H04N 25/772, H03F 3/08, H03M 1/56, H03M 1/12, H03F 1/22

(54) **PIXELS D'UN CAPTEUR DE LUMIERE**
PIXEL EINES LICHTSENSORS
PIXELS OF A LIGHT SENSOR

(30) Priorité: 15.07.2022 FR 2207272
(43) Date de publication de la demande: 17.01.2024
(73) Titulaire: Commissariat à l'énergie atomique et aux énergies alternatives, 75015 Paris (FR)
(72) Inventeur: AYEL, François, 38054 GRENOBLE CEDEX 09 (FR)
(74) Mandataire: Cabinet Beaumont

(56) Documents cités:
- US-A1- 2005 219 094
- US-A1- 2020 260 043
- BASTIDA E M ET AL: "A Design Approach for Mass Producible High-Bit-Rate MMIC Transimpedance Amplifiers", IEEE MICROWAVE AND GUIDED WAVE LETTERS, IEEE INC, NEW YORK, US, vol. 7, no. 10, 1 October 1997 (1997-10-01), XP011035220, ISSN: 1051-8207

## Description

### Domaine technique

La présente description concerne de façon générale les capteurs de lumière, et, plus particulièrement, les pixels de ces capteurs de lumière.

### Technique antérieure

Les capteurs de lumière comprenant une pluralité de pixels, par exemple organisés en matrice, sont connus. Dans un pixel d'un capteur de lumière, une quantité de lumière reçue par un ou plusieurs photodétecteurs du pixel pendant une phase d'intégration de la lumière par le pixel détermine une tension d'un noeud de détection du pixel. La lecture du pixel consiste alors à obtenir un signal représentatif de la valeur de la tension du noeud de détection. Ce signal représentatif de la tension du noeud de détection peut alors être comparé à une tension de comparaison pour obtenir un signal binaire dont l'état binaire indique si ce signal représentatif de la tension du noeud de détection est supérieur ou inférieur à la tension de comparaison. L'obtention du signal binaire constitue tout ou partie d'une conversion analogique-numérique.

Pour mettre en oeuvre la comparaison du signal représentatif de la tension du noeud de détection d'un pixel à la tension de comparaison, un comparateur est utilisé.

Par exemple, US 2020/260043 A1 divulgue un capteur de lumière dont chaque pixel inclut un comparateur de tension long-tail avec miroir de courant, les photocharges sont appliquées sur la grille d'un transistor NMOS, la tension de comparaison sur la grille d'un NMOS parallèle, un miroir de courant est en série avec les NMOS et un amplificateur suiveur de tension amplifie la sortie du comparateur.

### Résumé de l'invention

Il existe un besoin d'un capteur de lumière palliant tout ou partie des inconvénients des capteurs de lumière connus.

Un mode de réalisation pallie tout ou partie des inconvénients des capteurs de lumière connus, par exemple des pixels connus de ces capteurs de lumière connus.

Par exemple, un mode de réalisation prévoit un capteur de lumière dans lequel chaque pixel comprend un comparateur tel que décrit ci-dessous, le pixel étant plus compact que les pixels à comparateur intégré des capteurs de lumière connu.

Par exemple, un mode de réalisation prévoit un capteur de lumière dans lequel chaque pixel comprend un comparateur tel que décrit ci-dessous, le comparateur présentant moins de dispersions que celui des pixels à comparateur intégré des capteurs de lumière connu.

Par exemple, un mode de réalisation prévoit un capteur de lumière dans lequel chaque pixel comprend un comparateur tel que décrit ci-dessous, le comparateur présentant moins de dispersions que celui des pixels à comparateur intégré des capteurs de lumière connu.

Par exemple, un mode de réalisation prévoit un capteur de lumière mis en oeuvre dans un empilement de niveaux ("tier" ou "layer" en anglais) semiconducteurs qui nécessite moins de connexions par collage hybride ("hybrid bonding" en anglais) que les capteurs de lumière connus mis en oeuvre dans un empilement de niveaux semiconducteurs.

Un mode de réalisation prévoit un capteur de lumière comprenant une pluralité de pixels, chaque pixel comprenant :
un premier transistor MOS à canal d'un premier type et un deuxième transistor MOS à canal d'un second type, les premier et deuxième transistors étant connectés en série et ayant leurs sources connectées, une grille du deuxième transistor étant configurée pour recevoir une tension de comparaison ;
une première source de courant connectée en série avec les premier et deuxième transistors entre un premier noeud configuré pour recevoir un premier potentiel d'alimentation et un deuxième noeud configuré pour recevoir un deuxième potentiel d'alimentation ;
un troisième transistor MOS et une deuxième source de courant connectés en série entre un troisième noeud configuré pour recevoir un troisième potentiel d'alimentation et un quatrième noeud configuré pour recevoir un quatrième potentiel d'alimentation, le troisième transistor ayant une grille connectée à un cinquième noeud de connexion de la première source de courant aux premier et deuxième transistors en série et étant à canal du même type que celui du premier transistor ;
au moins une photodiode couplée à une grille du premier transistor ; et
un interrupteur de réinitialisation ayant une borne de conduction connectée à la grille du premier transistor.

Selon un mode de réalisation, une autre borne de conduction de l'interrupteur de réinitialisation est connectée au noeud de connexion de la deuxième source de courant au troisième transistor.

Selon un mode de réalisation, le capteur comprend en outre, pour chaque troisième transistor, un circuit de mise en forme ayant une entrée couplée au noeud de connexion de la deuxième source de courant au troisième transistor.

Selon un mode de réalisation :
ladite au moins une photodiode appartient à un substrat semiconducteur ; et
les premier, deuxième, troisième transistors, les première et deuxième sources de courant et l'interrupteur appartiennent à une couche semiconductrice reposant sur une couche isolante reposant elle-même sur ledit substrat semiconducteur.

Selon un mode de réalisation :
une première structure d'interconnexion repose sur la couche semiconductrice ;
le circuit de mise en forme appartient à une autre couche semiconductrice ou à un autre substrat semiconducteur ;
une deuxième structure d'interconnexion repose sur ladite autre couche semiconductrice ou ledit autre substrat semiconducteur ; et
un ensemble comprenant le substrat, la couche isolante, la couche semiconductrice et de la première structure d'interconnexion est assemblé sur un ensemble comprenant la deuxième structure d'interconnexion et de ladite autre couche semiconductrice ou dudit autre substrat semiconducteur, par collage hybride de la première structure d'interconnexion à la deuxième structure d'interconnexion.

Selon un mode de réalisation, le capteur comprend en outre un circuit configuré pour fournir la tension de comparaison.

Selon un mode de réalisation, la tension de comparaison comprend des rampes de tension.

Selon un mode de réalisation, les premier et troisième potentiels d'alimentation sont égaux et correspondent à la masse.

Selon un mode de réalisation, les deuxième et quatrième potentiels sont positifs par rapport à la masse, le premier transistor est à canal P, le deuxième transistor est à canal N, la première source de courant est connectée au deuxième noeud et la deuxième source de courant est connectée au troisième noeud.

Selon un mode de réalisation, dans chaque pixel, une grille de transfert couple ladite au moins une photodiode au premier transistor.

Selon un mode de réalisation, le premier transistor est monté en source suiveuse, le deuxième transistor est monté en source suiveuse et le troisième transistor est monté en source commune.

Selon un mode de réalisation, le noeud de connexion de la deuxième source de courant au troisième transistor MOS est adapté à fournir un signal indiquant un résultat d'une comparaison d'une tension sur la grille du premier transistor à la tension de comparaison.

Selon un mode de réalisation, pour au moins deux pixels du capteur, un unique deuxième transistor, une unique première source de courant, un unique troisième transistor et une unique deuxième source de courant mettent en oeuvre respectivement les deuxièmes transistors, les premières sources de courant, les troisièmes transistors et les deuxièmes sources de courant desdits au moins deux pixels.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un pixel d'un capteur de lumière ;
la figure 2 illustre par des chronogrammes un exemple de fonctionnement du pixel de la figure 1 ;
la figure 3 représente, par une vue en coupe schématique, un mode de réalisation du pixel de la figure 1 ; et
la figure 4 représente schématiquement un exemple d'un mode de réalisation d'un capteur comprenant une pluralité de pixels de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les systèmes, applications et circuits connus comprenant un capteur de lumière n'ont pas été décrits, les modes de réalisation et variantes décrits étant compatibles avec ces systèmes, applications et circuits connus.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, sauf indication contraire, chaque potentiel est référencé au potentiel de masse. En outre, sauf indication contraire, la tension d'un noeud est égale au potentiel de ce noeud référencé à la masse.

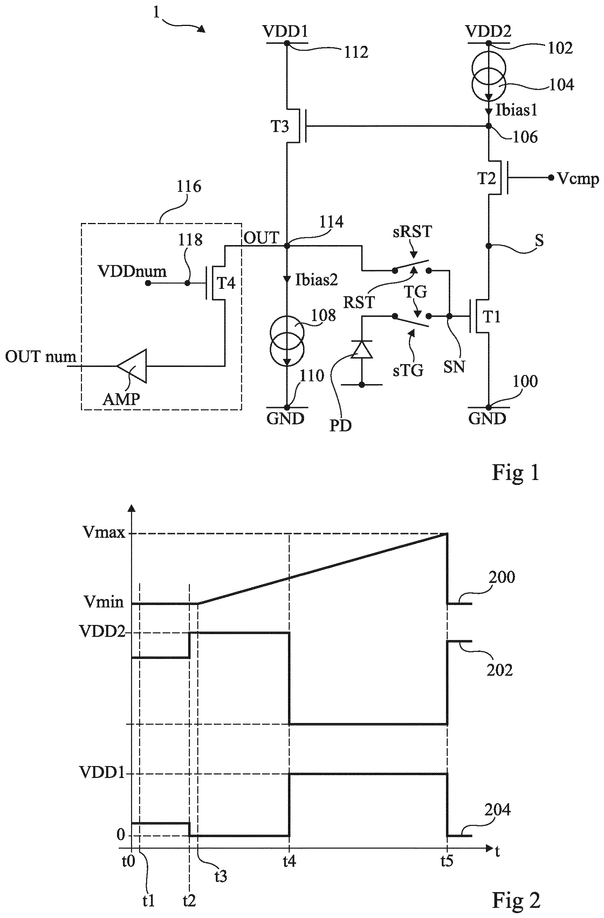

La figure 1 représente un mode de réalisation d'un pixel 1 d'un capteur de lumière.

Le pixel 1 comprend un transistor MOS ("Métal Oxyde Semiconducteur") T1 à canal d'un premier type parmi le type N et le type P. Dans l'exemple de la figure 1, le transistor T1 est à canal P, ou, dit autrement, est un transistor PMOS. Toutefois, dans d'autres exemples non illustrés, le transistor T1 est à canal N.

Le transistor T1 est monté en source suiveuse. La grille du transistor T1 est couplée, de préférence connectée, à un noeud de détection ("sense node" en anglais) SN.

Le pixel 1 comprend un transistor MOS T2 à canal d'un deuxième type parmi le type N et le type P. Dit autrement, le transistor T2 est à canal du type opposé à celui du canal du transistor T1. Dans l'exemple de la figure 1 où le transistor T1 est à canal P, le transistor T2 est donc à canal N, ou, dit autrement, est un transistor NMOS.

Le transistor T2 est monté en source suiveuse. La grille du transistor T2 est configurée pour recevoir une tension de comparaison Vcmp. La tension Vcmp est la tension à laquelle est comparée la tension du noeud SN. De préférence, la tension Vcmp est une tension ayant une valeur commandable. Par exemple, la grille du transistor T2 reçoit des rampes de tension Vcmp. A titre d'exemple, la tension Vcmp est fournie par un circuit générateur de tension du capteur de lumière comprenant le pixel 1, le capteur comprenant plusieurs pixels 1 et cette tension Vcmp étant, par exemple, fournie simultanément à tout ou partie des pixels 1 du capteur.

Les deux transistors T1 et T2 sont connectés en série l'un avec l'autre. Plus particulièrement, une première borne de conduction du transistor T1, à savoir sa source, est connectée à une première borne de conduction du transistor T2, à savoir la source du transistor T2. Dit autrement, les transistors T1 et T2 ont leurs sources S connectées l'une avec l'autre. Les deuxièmes bornes de conduction des transistors T1 et T2, à savoir leurs drains, sont couplées à des noeuds 100 et 102. Dit autrement, l'un des transistors T1 et T2 a son drain couplé au noeud 100, l'autre des transistors T1 et T2 ayant son drain couplé au noeud 102. Les transistors T1 et T2 sont donc connectés en série entre les deux noeuds 100 et 102.

Le noeud 100 est configuré pour recevoir un potentiel d'alimentation, par exemple la masse GND en figure 1. Le noeud 102 est configuré pour recevoir un autre potentiel d'alimentation VDD2. Dans l'exemple de la figure 1 où le transistor T1 est à canal P et le transistor T2 est à canal N, le potentiel VDD2 du noeud 102 est positif par rapport au potentiel GND du noeud 100. Dans un autre exemple non illustré où le transistor T1 est à canal N et le transistor T2 à canal P, le potentiel du noeud 102 est inférieur à celui du noeud 100, par exemple négatif par rapport au potentiel GND du noeud 100.

Le pixel 1 comprend en outre une source de courant 104. La source de courant 104 est connectée en série avec les transistors T1 et T2, entre les noeuds 100 et 102. Dit autrement, la source de courant 104 à une borne de conduction connectée à l'association en série des transistors T1 et T2, et, plus exactement, au drain de l'un des transistors T1 et T2. Dans la suite de la description, la référence 106 désigne le noeud de connexion de la source de courant 104 à l'association en série des transistors T1 et T2.

Dans l'exemple de la figure 1 où le transistor T1 est à canal P et le transistor T2 est à canal N, la source de courant 104 est connectée entre le transistor T2 et le noeud 102, et la référence 106 désigne alors le drain du transistor T2. Ainsi, dans l'exemple de la figure 1, le drain du transistor T2 est couplé au noeud 102, le drain du transistor T1 étant couplé, de préférence connecté, au noeud 100. Dit autrement, dans l'exemple de la figure 1, la source de courant 104 a une borne de conduction couplée, par exemple connectée, au noeud 102, et une autre borne de conduction couplée, par exemple connectée, au transistor T2.

Dans un autre exemple non illustré où le transistor T1 est à canal N et le transistor T2 est à canal P, la source de courant 104 couple le drain du transistor T1 au noeud 100, c'est à dire qu'elle est connectée entre le noeud 100 et le transistor T1, la référence 106 désignant alors le drain du transistor T1 et le drain du transistor T2 étant couplé, par exemple connecté, au noeud 102

La source 104 est, par exemple, configurée pour délivrer un courant constant Ibias1.

A titre d'exemple, la source 104 est mise en oeuvre par un transistor MOS ayant une grille configurée pour recevoir une tension continue de polarisation. Dans l'exemple de la figure 1 où la source de courant 104 couple le transistor T2 à canal N au noeud 102 recevant un potentiel supérieur à celui du noeud 100, le transistor MOS mettant en oeuvre la source de courant 104 est à canal P et a une borne de conduction, par exemple sa source, connectée au noeud 102 et une borne de conduction, par exemple son drain, connecté au noeud 106.

Dans le pixel 1, les transistors T1 et T2 sont passants lorsque la tension entre les grilles des transistors T1 et T2 est supérieure à la somme de la tension de seuil du transistor T1 et de la tension de seuil du transistor T2. Lorsque les transistors T1 et T2 sont bloqués, la borne de la source de courant 104 connectée au noeud 106 est à une tension sensiblement égale à la tension sur l'autre borne de la source de courant 104, à savoir la tension VDD2 du noeud 102 dans l'exemple de la figure 1. En revanche, dès que la différence entre la tension Vcmp et la tension du noeud SN est suffisante pour que les transistors T1 et T2 soient passants, la tension sur la borne de la source de courant 104 connectée au noeud 106 est tirée vers, ou se rapproche de, la tension sur celui des noeuds 100 et 102 qui n'est pas connectée à la source de courant 104, c'est à dire d'une tension nulle dans l'exemple de la figure 1.

La tension sur le noeud 106 est donc représentative de la comparaison de la tension Vcmp à la tension sur le noeud SN.

Le pixel 1 comprend au moins un photodétecteur PD, par exemple un seul photodétecteur PD dans l'exemple de la figure 1. Le noeud SN, c'est à dire la grille du transistor T1, est couplée au photodétecteur PD. Dans d'autres exemples non illustrés où le pixel 1 comprend plusieurs photodétecteurs PD, ceux-ci sont tous couplés au noeud SN.

Dans l'exemple de figure 1, le photodétecteur PD est une photodiode clampée ("pinned photodiode" en anglais), qui est alors couplée au noeud SN par une grille de transfert TG, représentée sous la forme d'un interrupteur en figure 1. La grille TG est connectée entre le noeud SN et la photodiode PD. La grille de transfert TG est commandé par un signal sTG, par exemple fournit par un circuit du capteur configuré pour commander les pixels 1 du capteur. En figure 1, la photodiode clampée PD est représentée connectée entre la grille TG et un noeud 108, par exemple mis à la masse GND bien que ce noeud puisse recevoir d'autres potentiels que la masse.

Dans un autre exemple non illustré, le photodétecteur PD est une photodiode non clampée. Dans cet autre exemple, la grille de transfert TG est de préférence omise, la photodiode PD étant alors directement connectée au noeud SN.

Le pixel 1 comprend en outre un transistor MOS T3 et une source de courant 108 connectés en série entre un noeud 110 et un noeud 112. Le noeud 110 est configuré pour recevoir un potentiel d'alimentation, à savoir la masse GND dans l'exemple de la figure 1, le noeud 112 étant configuré pour recevoir un autre potentiel d'alimentation VDD1. Dans l'exemple de la figure 1, le potentiel VDD1 est, comme le potentiel VDD2, supérieur au potentiel GND. Dit autrement, les potentiels des noeuds respectifs 112 et 102 ont une même polarité par rapport aux potentiels des noeuds respectivement 110 et 100. De préférence, les potentiels des noeuds 110 et 100 sont égaux. A titre d'exemple, les potentiels des noeuds 112 et 102 sont égaux bien que, dans d'autres exemples, le potentiel VDD2 puisse être différent du potentiel VDD1, de préférence supérieur au potentiel VDD1.

Le transistor T3 a sa grille connectée au noeud 106. Le transistor T3 est, par exemple, configuré pour fournir le gain du comparateur du pixel 1, ce comparateur étant mis en oeuvre par les éléments T1, T2, T3, 104 et 108.

Le transistor T3 est canal du type opposé au type du canal du transistor T2 mais de même type que le type du canal du transistor T1. Ainsi, dans l'exemple de la figure 1, le transistor T3 est canal P. Dans un autre exemple non illustré où le transistor T1 est à canal N, le transistor T2 est à canal P et la source de courant 104 couple le drain du transistor T1 au noeud 100, le transistor T3 a sa grille connectée au noeud 106 de connexion du transistor T1 à la source de courant 104, et est à canal du type N.

Le transistor T3 est montée en source commune. Ainsi, dans l'exemple de la figure 1 où le transistor T3 est à canal P, le transistor T3 a sa source connectée au noeud 112, et la source de courant 108 couple le drain du transistor T3 au noeud 110, la source de courant 108 ayant, par exemple, une borne connectée au drain du transistor T3 et une borne connectée au noeud 110. Dans d'autres exemples où le transistor T3 est canal N, le transistor T3 a sa source connectée au noeud 100 et la source de courant 108 couple le drain du transistor T3 au noeud 112.

La source de courant 108 est configurée pour fournir un courant constant Ibias2 de polarisation du transistor T3. A titre d'exemple, la source de courant 108 est mise en oeuvre par un transistor MOS ayant sa grille configurée pour recevoir une tension de polarisation, et son drain couplé, de préférence connecté au noeud 114. Dans l'exemple de la figure 1, ce transistor MOS est à canal N.

Le noeud 114 de connexion du transistor T3 à la source de courant 108 est adapté à fournir un signal OUT indiquant un résultat d'une comparaison d'une tension sur la grille du premier transistor à la tension de comparaison.

Selon un mode de réalisation, le signal OUT est le signal de sortie du pixel 1.

Selon un autre mode de réalisation illustré par exemple par la figure 1, le pixel 1 comprend en outre un circuit tampon ("buffer circuit" en anglais) 116. Le circuit 116 reçoit le signal OUT et fournir un signal binaire OUTnum a un premier état binaire si la tension entre les grilles des transistors T1 et T2 est supérieure à la somme de la tension de la tension de seuil du transistor T1 et de la tension de seuil du transistor T2, et dans un deuxième état binaire sinon. Dit autrement, le circuit 116 est un circuit de mise en forme du signal OUT.

Le signal OUTnum est, comme le signal OUT, représentatif du résultat de la comparaison de la tension du noeud SN à la tension Vcmp.

A titre d'exemple, le circuit 116 comprend un transistor MOS T4 et un amplificateur AMP. Le transistor T4 couple le noeud 114 à une entrée de l'amplificateur AMP. La grille du transistor T4 est connecté à un noeud 118 configuré pour recevoir une tension d'alimentation VDDnum du circuit 116, par exemple de l'amplificateur AMP. Le transistor T4 permet donc d'adapter la tension maximale prise par le signal OUT à la tension d'alimentation de l'amplificateur. A titre d'exemple, la tension VDDnum est une tension d'alimentation des circuits numériques du capteur, par exemple des circuits numériques de traitement des signaux de sortie des pixels 1 du capteur. La sortie de l'amplificateur AMP fournit le signal OUTnum. Bien entendu, la personne du métier est en mesure de prévoir d'autres circuits 116 de mise en forme du signal OUT que celui décrit ici en relation avec la figure 1.

Le pixel 1 comprend en outre un interrupteur RST configuré pour initialiser la tension du noeud SN. L'interrupteur de réinitialisation RST est commandé par un signal sRST, par exemple fournit par le circuit du capteur configuré pour commander les pixels 1 du capteur. L'interrupteur RST a une borne couplée, de préférence connectée, au noeud SN. L'autre borne de l'interrupteur RST est, dans le mode de réalisation de la figure 1, connectée au noeud 114.

Par rapport à un pixel comprenant un comparateur mis en oeuvre à partir d'une paire différentielle ayant une entrée connectée à un noeud de détection du pixel, le pixel 1 est plus compact du fait que son comparateur comprend moins de transistors MOS qu'un comparateur mis en oeuvre à partir d'une paire différentielle. En outre, pour une même consommation, le gain du comparateur du dispositif 1 est supérieur au gain qu'aurait un comparateur mis en oeuvre à partir d'une paire différentielle, ce qui augmente la précision de comparaison.

La figure 2 illustre par des chronogrammes un exemple de fonctionnement du pixel 1 de la figure 1. Plus particulièrement, la figure 2 représente par des chronogrammes 200, 202 et 204 l'allure respectivement de la tension Vcmp, de la tension du noeud 106 et de la tension OUT.

Dans l'exemple de la figure 2, les transistors T1 et T3 sont à canal P, le transistor T2 est à canal N, les potentiels VDD1 et WD2 sont positifs par rapport au potentiel GND des noeuds 110 et 100, et la source de courant 104 couple le drain du transistor T2 au noeud 102. En outre, dans cet exemple, la grille du transistor T2 reçoit des rampes de tension Vcmp, par exemple des rampes croissantes.

A un instant t0, l'interrupteur RST est fermé et le potentiel du noeud SN est initialisé à une valeur déterminée par le potentiel sur la borne de conduction de l'interrupteur RST qui n'est pas connectée au noeud SN.

Dans ce mode de réalisation, l'interrupteur RST est connecté entre le noeud SN et le noeud 114. Le potentiel sur le noeud SN s'établit donc à une valeur déterminée par :
- la valeur de la tension Vcmp sur la grille du transistor T2 lorsque l'interrupteur RST est fermé,
- la tension de seuil Vt1 du transistor T1, et
- la tension de seuil Vt2 du transistor T2.

Cela permet de tenir compte des dispersions présentes dans le comparateur du pixel 1, par exemple des dispersions sur les tensions de seuils des transistors T1, T2 et T3. En particulier, pour une consommation équivalente et pour une surface occupée équivalente, le comparateur du pixel 1 présente moins de dispersion qu'un comparateur mis en oeuvre à partir d'une paire différentielle. Dit autrement, dans ce mode de réalisation, l'interrupteur RST permet de faire une correction du décalage ("offset" en anglais) du comparateur du pixel 1.

Dans l'exemple considéré ici et illustré par la figure 2, la photodiode PD du pixel 1 est clampée et est couplée au noeud SN par la grille de transfert TG (figure 1). Afin de vider la photodiode PD de ces charges, à l'instant t0, la grille de transfert TG est passante. Dans l'exemple illustré où le transistor T1 est à canal P, la photodiode PD est configurée pour stocker des trous, et c'est pour cela que, à l'instant t0, la grille du transistor T2 reçoit une valeur minimale Vmin des rampes Vcmp. A l'instant t0, la tension sur le noeud SN s'établit donc à une valeur égale à Vmin - Vt1 - Vt2.

Dans un autre exemple non illustré où le transistor T1 est à canal N, la photodiode clampée PD est configurée pour stocker des électrons et la grille du transistor T2 reçoit alors une tension supérieure à la tension Vmin, par exemple la tension maximale Vmax des rampes Vcmp.

Plus généralement, la personne du métier sera en mesure d'adapter la valeur de la tension reçue par la grille du transistor T2 lors d'une phase de réinitialisation du noeud SN comprenant la mise à l'état passant de l'interrupteur RST connecté entre le noeud SN et le noeud 114, par exemple pour tenir compte du type de charges stockées dans la photodiode PD pendant une phase d'intégration.

Après l'instant t0, dans cet exemple où la photodiode PD est clampée, la grille de transfert TG est commutée à l'état bloquée, par exemple à un instant t1 postérieur à l'instant t0, et une phase d'intégration de la lumière par la photodiode PD débute.

Entre l'instant t1 et un instant t2 postérieur à l'instant t1, l'interrupteur RST est commuté à l'état bloqué. A l'instant t2, la grille de transfert TG est commutée à l'état passant puis à l'état bloqué, la commutation de la grille TG à l'état bloquée marquant la fin de la période d'intégration. Pendant que la grille TG est passante, les charges photogénérées et accumulées dans la photodiode PD pendant la période d'intégration sont transférées sur le noeud SN, d'où il résulte une modification de la tension du noeud SN. Dans cet exemple où la photodiode est configurée pour stocker des trous, le transfert des charges de la photodiode PD vers le noeud SN résulte en une augmentation de la tension du noeud SN.

L'augmentation de la tension du noeud SN à l'instant t2 résulte en une diminution de la tension entre les grilles des transistors T1 et T2, qui commutent alors à l'état bloqué. Cela entraîne que la tension sur le noeud 106 devient sensiblement égale à VDD2 dans cet exemple où la source de courant 104 est connectée au noeud 102. En outre, du fait que la tension du noeud 106 est sensiblement égale à VDD2, qui est supérieur ou égal à VDD1, le transistor T3 est bloqué et la tension du noeud 114 est sensiblement nulle dans cet exemple où la source de courant 108 est connectée au noeud 110 recevant la masse GND.

A un instant t3 postérieur à l'instant t2, une phase de lecture du pixel 1 débute. Pendant cette phase de lecture la tension du noeud SN est comparée à la tension Vcmp. Dans cet exemple, l'instant t3 correspond au début d'une rampe de tension Vcmp croissante.

A un instant t4 postérieur à l'instant t3, la tension Vcmp atteint une valeur telle que la tension entre les grilles des transistors T1 et T2 est suffisante pour que ces transistors commutent à l'état passant, ou, dit autrement, pour que le courant Ibias1 circule à travers les transistors T1 et T2. Il en résulte que la tension du noeud 106 est tirée vers la tension du noeud 100 auquel la source 104 n'est pas connectée, bien qu'en pratique la tension du noeud 106 ne puisse pas descendre en dessous de la somme de la tension du noeud SN et de la tension de seuil du transistor T1. Cela entraîne la commutation à l'état passant du transistor T3, ou, dit autrement, une circulation du courant Ibias2 à travers le transistor T3, d'où il résulte que la tension du noeud 114 devient sensiblement égale à la tension VDD1.

A un instant t5 postérieur à l'instant t4, la rampe Vcmp atteint la valeur Vmax puis la tension Vcmp est commutée à la valeur Vmin, ce qui marque la fin de la phase de lecture du pixel 1. Il en résulte que les tensions des noeuds 106 et 114 retrouvent les niveaux qu'elles avaient entre les instants t2 et t3.

La durée de l'état haut (ou bas) du signal OUT pendant la rampe de tension Vcmp, c'est à dire de l'instant t3 à l'instant t4, est représentative de la valeur de la tension du noeud SN après l'instant t2 de transfert des charges de la photodiode PD vers le noeud SN, donc de la quantité de lumière reçue par la photodiode PD pendant la phase d'intégration (de l'instant t1 à l'instant t2.

Un avantage du fonctionnement décrit ci-dessus, et, en particulier du fait que l'interrupteur RST est connecté au noeud 114, est qu'il n'y a pas besoin de mettre en oeuvre une lecture de type à double échantillonnage corrélé (CDS de l'anglais "Correlated Double Sampling").

La personne du métier sera en mesure d'adapter le fonctionnement décrit ci-dessus au cas où le transistor T1 est à canal N, la source de courant 104 est connectée au noeud 100 plutôt qu'au noeud 102 et la photodiode PD clampée est configurée pour stocker des électrons.

On a décrit ici un exemple où la tension de comparaison Vcmp présente une rampe croissante pendant la phase de lecture du pixel. La personne du métier est en mesure d'adapter cette description au cas où la rampe Vcmp est décroissante, par exemple en commutant la tension Vcmp à la valeur Vmax à l'instant t3 de début de la phase de lecture, la rampe Vcmp décroissant alors de la valeur Vmax à l'instant t3 jusqu'à la valeur Vmin à l'instant t4.

Par ailleurs, dans des applications, il est souhaitable de déterminer rapidement si la quantité de lumière reçue par un pixel 1 pendant une phase d'intégration est supérieure ou non à un seuil. Dans ce cas, plutôt que de prévoir une rampe de tension Vcmp pendant la phase de lecture, la tension Vcmp a alors, pendant la phase de lecture de la tension du noeud SN, une valeur constante déterminée par la valeur du seuil susmentionné. L'état du signal OUT pendant la phase de lecture indique alors directement si la quantité de lumière reçue est supérieure ou non au seuil.

On a décrit ci-dessus un exemple de fonctionnement pour un mode de réalisation où l'interrupteur RST est connecté au noeud 114 (figure 1). Dans un autre mode de réalisation, l'interrupteur RST est connecté entre le noeud SN et un noeud configuré pour recevoir un potentiel de réinitialisation. A titre d'exemple, ce potentiel de réinitialisation est choisi sensiblement égal à la valeur du potentiel qu'a le noeud 114 lorsque l'interrupteur RST est connecté à ce noeud 114 et est passant. Dans ce cas, afin de tenir compte des dispersions, il peut être souhaitable de mettre en oeuvre un double échantillonnage corrélé, par exemple en mettant en oeuvre successivement :
- une lecture de la tension du noeud SN après une réinitialisation du noeud SN, la réinitialisation du noeud SN comprenant une mise à l'état passant de l'interrupteur RST ;
- un transfert des charges accumulées dans la photodiode PD vers le noeud SN, le transfert comprenant une mise à l'état passant de la grille de transfert TG alors que l'interrupteur RST est à l'état bloqué ; et
- une deuxième lecture de la tension du noeud SN après ledit transfert.

De plus, dans l'exemple décrit en relation avec la figure 2, la photodiode PD est clampée. La personne du métier sera en mesure d'adapter la description faite ci-dessus au cas où la photodiode PD n'est pas clampée, l'interrupteur RST est connecté à un noeud différent du noeud 114 et l'interrupteur RST est configuré pour recevoir un potentiel de réinitialisation, par exemple en mettant en oeuvre successivement :
- une première réinitialisation du noeud SN, comprenant une mise à l'état passant de l'interrupteur RST ;
- une lecture de la tension du noeud SN indiquant la quantité de lumière reçue par le pixel 1 depuis la première réinitialisation du noeud SN ;
- une deuxième réinitialisation du noeud SN en mettant l'interrupteur RST à l'état passant et une lecture de la tension du noeud SN alors que l'interrupteur RST est passant.

Les modes de réalisation et variantes du pixel 1 décrit ci-dessus en relation avec les figures 1 et 2 peuvent être mis en oeuvre de différentes façons.

Par exemple, l'ensemble du pixel 1 peut être mis en oeuvre à partir d'une unique couche semiconductrice (ou niveau semiconducteur), les transistors T1, T2, T3, les sources de courant 104, 108, la ou les photodiodes PD, l'interrupteur RST, la grille TG (lorsqu'elle est présente) et le circuit 116 (lorsqu'il est présent) du pixel 1 étant alors tous mis en oeuvre à partir de cette unique couche semiconductrice.

A titre d'exemple alternatif, la ou les photodiodes PD, l'interrupteur RST et la grille TG (lorsqu'elle est présente) du pixel 1 sont mis en oeuvre à partir d'une première couche semiconductrice (ou premier niveau semiconducteur), les autres éléments du pixel 1 étant mis en oeuvre à partir d'une deuxième couche semiconductrice, les deux couches étant alors empilées et couplée électriquement l'une à l'autre.

Plus généralement, les éléments constitutifs du pixel 1 peuvent être mis en oeuvre à partir de plusieurs couches semiconductrices empilées les unes sur les autres et couplées électriquement les unes aux autres.

A titre d'exemple, dans un capteur comprenant plusieurs pixels 1, chaque pixel 1 est mis en oeuvre de manière similaire, ou, dit autrement, la répartition des éléments constitutifs de chaque pixel 1 entre plusieurs niveaux semiconducteurs est identique à celle des autres pixels 1 du capteur.

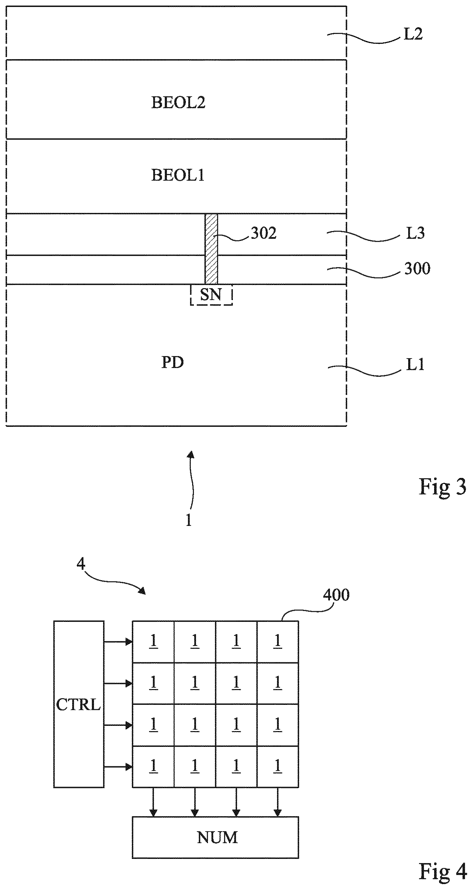

La figure 3 représente, par une vue en coupe schématique, un mode de mise en du pixel de la figure 1. Dans ce mode de mise en oeuvre, la photodiode PD et la grille TG (lorsqu'elle est présente) sont mises en oeuvre dans un premier niveau semiconducteur L1, le circuit 116 est mis en oeuvre dans un deuxième niveau semiconducteur L2 et le reste des éléments du pixel 1 (transistor T1, T2, T3, sources de courant 104, 108 et interrupteur RST) sont mis en oeuvre dans un troisième niveau semiconducteur L3, les niveaux L1, L2 et L3 étant empilés.

Plus particulièrement, le niveau L1 correspond à un substrat semiconducteur, par exemple en silicium.

Le niveau L3 correspond à une couche semiconductrice, par exemple en silicium. La couche L3 repose sur et en contact avec une couche isolante 300, la couche L3 reposant sur et en contact avec le substrat L1.

A titre d'exemple, la couche isolante 300 a été formée, par exemple déposée, sur le substrat L1 après la formation des tranchées d'isolement, par exemple capacitives, délimitant la photodiode PD et la formation de la grille de transfert TG. A titre d'exemple, la couche semiconductrice L3 a été formée sur la couche isolante 300, par exemple par épitaxie.

Une structure d'interconnexion de type fin de ligne ("back end of line interconnexion structure" en anglais) BEOL1 repose sur et en contact avec la couche L3.

A titre d'exemple, la structure BEOL1 comprend des couches isolantes dans lesquelles sont noyées des portions de couches conductrices reliées entre elles par des vias conducteurs. A titre d'exemple, la structure BEOL1 est formée après la formation, dans et sur la couche L3, des transistors T1, T2, T3 (non représentés en figure 3), des sources de courant 104, 108 (non représentées en figure 3) et de l'interrupteur RST (non représenté en figure 3).

A titre d'exemple, un via conducteur 302 traverse la couche isolante 300 et la couche semiconductrice L3 pour connecter le noeud SN à la structure BEOL1. Bien que cela ne soit pas représenté en figure 3, au moins la portion du via 302 traversant la couche L3 est revêtue latéralement d'un isolant pour être isoler électriquement de la couche L3.

Le niveau L2 correspond par exemple à un substrat semiconducteur ou à une couche semiconductrice de type silicium sur isolant. Le niveau L2 est par exemple en silicium.

Une structure d'interconnexion de type fin de ligne ("back end of line interconnexion structure" en anglais) BEOL2 repose sur et en contact avec le niveau L2. A titre d'exemple, la structure BEOL2 comprend des couches isolantes dans lesquelles sont noyées des portions de couches conductrices reliées entre elles par des vias conducteurs.

Afin de coupler électriquement les niveaux L1 et L3 au niveau L2, l'ensemble du niveau L1, de la couche 300, du niveau L2 et de la structure BEOL1, qui constitue par exemple une première puce de circuit intégré, est monté par collage hybride sur l'ensemble du niveau L2 et de la structure BEOL2, qui constitue par exemple une deuxième puce de circuit intégré, en mettant en contact l'une avec l'autre les deux structures BEOL1 et BEOL2.

Dans le mode de réalisation illustré par la figure 3, pour chaque pixel 1, il n'y a besoin que d'une seule connexion électrique entre la structure BEOL1 et BEOL2, qui correspond alors au noeud 114 du pixel 1. Cette connexion électrique est, par exemple, faite par collage hybride d'un plot conducteur de la structure BEOL1 avec un plot conducteur de la structure BEOL2.

La figure 4 représente, de manière schématique et sous la forme de blocs, un mode de réalisation d'un capteur 4 comprenant une pluralité de pixels 1, par exemple agencé sous la forme d'une matrice 400 comprenant des lignes et des colonnes de pixels 1. Dans l'exemple de la figure 4, la matrice 400 comprend quatre lignes et quatre colonnes de pixels 1, bien que la matrice 400 puissent comprendre un nombre plus grand, par exemple supérieur à mille, de colonnes et un nombre plus grand, par exemple supérieur à mille, de lignes.

Le capteur 4 comprend un circuit de commande CTRL configuré pour commander les pixels 1 du capteur 4. Par exemple, le circuit CTRL fourni des signaux identiques à tous les pixels 1 d'une même ligne, c'est à dire que tous les pixels 1 d'une même ligne sont commandés de manière identique. A titre d'exemple alternatif, le circuit CTRL fourni des signaux identiques à tous les pixels 1 de la matrice, c'est à dire que tous les pixels 1 de la matrice sont commandés de manière identique.

Le capteur 4 comprend en outre un circuit de traitement NUM des signaux de sortie des pixels 1, par exemple des signaux OUTnum (figure 1) de sortie des pixels 1. Par exemple, lorsque le circuit CTRL commande la lecture d'une ligne de pixels 1, les signaux de sortie de tous les pixels 1 de cette ligne sont reçus en parallèle par le circuit NUM, le circuit NUM étant alors par exemple en mesure de déterminé pour chacun des signaux reçus en parallèle, de quelle colonne provient le signal. A titre d'exemple alternatif, lorsque le circuit CTRL commande la lecture simultanée de tous les pixels 1 de la matrice, les signaux de sortie de tous les pixels 1 sont reçus en parallèle par le circuit NUM, ce dernier étant alors par exemple en mesure de détecter, pour chaque signal de sortie reçu, le pixel 1 ayant fourni ce signal de sortie, par exemple en mettant en oeuvre une détection ligne/colonne.

La personne du métier pourra prévoir de mettre en oeuvre des capteurs de lumière comprenant plusieurs pixels 1, qui soient différents de celui de la figure 4.

Par exemple, la personne du métier sera en mesure de prévoir des capteurs de lumière comprenant des matrices de pixels 1 ayant des architectures événementielles ("event driven" en anglais) où les signaux de sortie des pixels sont par exemple traités en fonction des instants où chacun des ces signaux commutent. De telles architectures sont par exemple présentées dans les documents "A 1280×720 Back-Illuminated Stacked Temporal Contrast Event-Based Vision Sensor with 4.86pm Pixels, 1.066GEPS Readout, Programmable Event-Rate Controller and Compressive Data-Formatting Pipeline" de Thomas Finateu, Atsumi Niwa, Daniel Matolin, Koya Tsuchimoto, Andrea Mascheroni, Etienne Reynaud et Pooria Mostafalu ; "A 1280x960 Dynamic Vision Sensor with a 4.95- µm Pixel Pitch and Motion Artifact Minimization" de Yunjae Suh, Seungnam Choi, Masamichi Ito, Jeongseok Kim, Youngho Lee, Jongseok Seo, Heejae Jung, Dong-Hee Yeo, Seol Namgung, Jongwoo Bong, Sehoon Yoo, Seung-Hun Shin, Doowon Kwon, Pilkyu Kang, Seokho Kim, Hoonjoo Na, Kihyun Hwang, Changwoo Shin, Jun-Seok Kim, Paul K. J. Park, Joonseok Kim, Hyunsurk Ryu et Yongin Park ; et "Development of Event-based Sensor and Applications" de Shoushun chen de la société Omnivision sensor solutions.

Par ailleurs, dans le cas d'un capteur de lumière comprenant plusieurs pixels 1, plutôt que de prévoir que chaque pixel 1 comprenne un transistor T2 dédié, un transistor T3 dédié, une source de courant 104 dédiée, une source de courant 108 dédiée, et, lorsqu'il est présent, un circuit 116 dédié, il est possible de mutualiser ces éléments T2, T3, 104, 108 et 116 entre plusieurs pixels 1. Dit autrement, pour moins deux pixels 1 du capteur, le transistor T2, le transistor T3, la source de courant 104, la source de courant 108 et, lorsqu'il est prévu, le circuit 116 de chacun de ces au moins deux pixels sont mis en oeuvre respectivement par un unique transistor T2, un unique transistor T3, une unique source de courant 104, une unique source de courant 108 et un unique circuit 116. Dit encore autrement, cet unique transistor T2, cet unique transistor T3, cette unique source de courant 104, cette unique source de courant 108 et cet unique circuit 116 sont partagés par ces au moins deux pixels 1. La mutualisation d'au moins certains composants d'un pixel 1 entre plusieurs pixels 1 d'un capteur est à la portée de la personne du métier.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que l'on ait décrit des exemples de modes de réalisation et de variantes dans lesquels les potentiels des noeuds 102 et 112 sont positifs par rapport aux potentiels des noeuds 100 et 110, dans d'autres exemples les potentiels des noeuds 102 et 112 peuvent être négatifs par rapport aux potentiels des noeuds 100 et 110, par exemple en prévoyant d'inverser les types N et P du canal de chacun des transistors décrits précédemment.

Enfin, la mise en oeuvre pratique des modes de réalisation et variantes décrits est à la portée de la personne du métier à partir des indications fonctionnelles données ci-dessus.

## Revendications

1. Capteur de lumière (4) comprenant une pluralité de pixels (1), chaque pixel comprenant :
un premier transistor MOS (T1) à canal d'un premier type et un deuxième transistor MOS (T2) à canal d'un second type, les premier et deuxième transistors (T1, T2) étant connectés en série et ayant leurs sources (S) connectées, une grille du deuxième transistor (T2) étant configurée pour recevoir une tension de comparaison (Vcmp) ;
une première source de courant (104) connectée en série avec les premier et deuxième transistors (T1, T2) entre un premier noeud (100) configuré pour recevoir un premier potentiel d'alimentation (GND) et un deuxième noeud (102) configuré pour recevoir un deuxième potentiel d'alimentation (VDD2) ;
un troisième transistor MOS (T3) et une deuxième source de courant (108) connectés en série entre un troisième noeud (110) configuré pour recevoir un troisième potentiel d'alimentation (GND) et un quatrième noeud (112) configuré pour recevoir un quatrième potentiel d'alimentation (VDD1), le troisième transistor (T3) ayant une grille connectée à un cinquième noeud (106) de connexion de la première source de courant (104) aux premier et deuxième transistors (T1, T2) en série et étant à canal du même type que celui du premier transistor (T1) ;
au moins une photodiode (PD) couplée à une grille du premier transistor (T1) ; et
un interrupteur de réinitialisation (RST) ayant une borne de conduction connectée à la grille du premier transistor (T1).

2. Capteur selon la revendication 1, dans lequel une autre borne de conduction de l'interrupteur de réinitialisation (RST) est connectée au noeud (114) de connexion de la deuxième source de courant (108) au troisième transistor (T3).

3. Capteur selon la revendication 1 ou 2, dans lequel le capteur (4) comprend en outre, pour chaque troisième transistor (T3), un circuit (116) de mise en forme ayant une entrée couplée au noeud (114) de connexion de la deuxième source de courant (108) au troisième transistor (T3).

4. Capteur selon l'une quelconque des revendications 1 à 3, dans lequel :
ladite au moins une photodiode (PD) appartient à un substrat semiconducteur (L1) ; et
les premier, deuxième, troisième transistors (T1, T2, T3), les première et deuxième sources de courant (104, 108) et l'interrupteur (RST) appartiennent à une couche semiconductrice (L3) reposant sur une couche isolante (300) reposant elle-même sur ledit substrat semiconducteur (L1).

5. Capteur selon la revendication 4 prise dans sa dépendance à la revendication 3, dans lequel :
une première structure d'interconnexion (BEOL1) repose sur la couche semiconductrice (L3) ;
le circuit de mise en forme (116) appartient à une autre couche semiconductrice (L2) ou à un autre substrat semiconducteur (L2) ;
une deuxième structure d'interconnexion (BEOL2) repose sur ladite autre couche semiconductrice (L2) ou ledit autre substrat semiconducteur (L2) ; et
un ensemble comprenant le substrat (L1), la couche isolante (300), la couche semiconductrice (L3) et de la première structure d'interconnexion (BEOL1) est assemblé sur un ensemble comprenant la deuxième structure d'interconnexion (BEOL2) et de ladite autre couche semiconductrice (L2) ou dudit autre substrat semiconducteur (L2), par collage hybride de la première structure d'interconnexion (BEOL1) à la deuxième structure d'interconnexion (BEOL2).

6. Capteur selon l'une quelconque des revendications 1 à 5, dans lequel le capteur (4) comprend en outre un circuit configuré pour fournir ladite tension de comparaison (Vcmp).

7. Capteur selon la revendication 6, dans lequel ladite tension de comparaison (Vcmp) comprend des rampes de tension.

8. Capteur selon l'une quelconque des revendications 1 à 7, dans lequel les premier et troisième potentiels d'alimentation sont égaux et correspondent à la masse.

9. Capteur selon la revendication 8, dans lequel les deuxième et quatrième potentiels sont positifs par rapport à la masse, le premier transistor (T1) est à canal P, le deuxième transistor (T2) est à canal N, la première source de courant (104) est connectée au deuxième noeud (102) et la deuxième source de courant (108) est connectée au troisième noeud (110) .

10. Capteur selon l'une quelconque des revendications 1 à 9, comprenant, dans chaque pixel (1), une grille de transfert (TG) couplant ladite au moins une photodiode au premier transistor (T1).

11. Capteur selon l'une quelconque des revendications 1 à 10, dans lequel le premier transistor (T1) est monté en source suiveuse, le deuxième transistor (T2) est monté en source suiveuse et le troisième transistor (T3) est monté en source commune.

12. Capteur selon l'une quelconque des revendications 1 à 11, dans lequel le noeud (114) de connexion de la deuxième source de courant (108) au troisième transistor MOS (T3) est adapté à fournir un signal (OUT) indiquant un résultat d'une comparaison d'une tension sur la grille du premier transistor (T1) à la tension de comparaison (Vcmp).

13. Capteur selon l'une quelconque des revendications 1 à 12, dans lequel, pour au moins deux pixels (1) du capteur, un unique deuxième transistor (T2), une unique première source de courant (104), un unique troisième transistor (T3) et une unique deuxième source de courant (108) mettent en oeuvre respectivement les deuxièmes transistors (T2), les premières sources de courant (104), les troisièmes transistors (T3) et les deuxièmes sources de courant (108) desdits au moins deux pixels.

## Patentansprüche

1. Lichtsensor (4), der eine Vielzahl von Pixeln (1) aufweist, wobei jedes Pixel Folgendes aufweist:
einen ersten MOS-Transistor (T1) mit einem ersten Kanaltyp und einen zweiten MOS-Transistor (T2) mit einem zweiten Kanaltyp, wobei der erste und der zweite Transistor (T1, T2) in Reihe geschaltet sind und ihre Sources (S) verbunden sind, wobei ein Gate des zweiten Transistors (T2) eingerichtet ist zum Empfangen einer Vergleichsspannung (Vcmp);
eine erste Stromquelle (104), die mit dem ersten und dem zweiten Transistor (T1, T2) in Reihe geschaltet ist zwischen einem ersten Knoten (100), der eingerichtet ist zum Empfangen einer ersten Versorgungsspannung (GND), und einem zweiten Knoten (102), der eingerichtet ist zum Empfangen einer zweiten Versorgungsspannung (VDD2);
einen dritten MOS-Transistor (T3) und eine zweite Stromquelle (108), in Reihe geschaltet zwischen einem dritten Knoten (110), der eingerichtet ist zum Empfangen einer dritten Versorgungsspannung (GND), und einem vierten Knoten (112), der eingerichtet ist zum Empfangen einer vierten Versorgungsspannung (VDD1), wobei der dritte Transistor (T3) ein Gate hat, das mit einem fünften Verbindungsknoten (106) der ersten Stromquelle (104) mit den ersten und zweiten Transistoren (T1, T2) in Reihe geschaltet ist, und einen Kanal des gleichen Typs wie der des ersten Transistors (T1) hat;
wenigstens eine Fotodiode (PD), die mit einem Gate des ersten Transistors (T1) gekoppelt ist; und
einen Rücksetzschalter (RST), der einen Leitungsanschluss hat, der mit dem Gate des ersten Transistors (T1) verbunden ist.

2. Sensor nach Anspruch 1, wobei ein weiterer Leitungsanschluss des Rücksetzschalters (RST) mit dem Verbindungsknoten (114) der zweiten Stromquelle (108) zum dritten Transistor (T3) verbunden ist.

3. Sensor nach Anspruch 1 oder 2, wobei der Sensor (4) außerdem für jeden dritten Transistor (T3) eine Formgebungsschaltung (116) aufweist, die einen Eingang hat, der mit dem Verbindungsknoten (114) der zweiten Stromquelle (108) zum dritten Transistor (T3) gekoppelt ist.

4. Sensor nach einem der Ansprüche 1 bis 3, wobei:
die wenigstens eine Fotodiode (PD) zu einem Halbleitersubstrat (L1) gehört; und
die ersten, zweiten und dritten Transistoren (T1, T2, T3), die ersten und zweiten Stromquellen (104, 108) und der Schalter (RST) zu einer Halbleiterschicht (L3) gehören, die auf einer Isolierschicht (300) liegt, die auf dem Halbleitersubstrat (L1) liegt.

5. Sensor nach Anspruch 4 in seiner Abhängigkeit von Anspruch 3, wobei:
eine erste Verbindungsstruktur (BEOL1) auf der Halbleiterschicht (L3) liegt;
die Formgebungsschaltung (116) zu einer anderen Halbleiterschicht (L2) oder zu einem anderen Halbleitersubstrat (L2) gehört;
eine zweite Verbindungsstruktur (BEOL2) liegt auf der anderen Halbleiterschicht (L2) oder dem anderen Halbleitersubstrat (L2); und
ein Set, das das Substrat (L1), die Isolierschicht (300), die Halbleiterschicht (L3) und die erste Verbindungsstruktur (BEOL1) aufweist, auf einem Set montiert ist, das die zweite Verbindungsstruktur (BEOL2) und die andere Halbleiterschicht (L2) oder das andere Halbleitersubstrat (L2) aufweist, und zwar durch hybrides Bonden der ersten Verbindungsstruktur (BEOL1) mit der zweiten Verbindungsstruktur (BEOL2).

6. Sensor nach einem der Ansprüche 1 bis 5, wobei der Sensor (4) ferner eine Schaltung aufweist, die eingerichtet ist zum Bereitstellen der Vergleichsspannung (Vcmp).

7. Sensor nach Anspruch 6, wobei die Vergleichsspannung (Vcmp) Spannungsrampen aufweist.

8. Sensor nach einem der Ansprüche 1 bis 7, wobei die erste und die dritte Versorgungsspannung gleich sind und Masse entsprechen.

9. Sensor nach Anspruch 8, wobei die zweite und die vierte Versorgungsspannung relativ zur Masse positiv sind, der erste Transistor (T1) einen P-Typ-Kanal hat, der zweite Transistor (T2) einen N-Typ-Kanal hat, die erste Stromquelle (104) mit dem zweiten Knoten (102) verbunden ist und die zweite Stromquelle (108) mit dem dritten Knoten (110) verbunden ist.

10. Sensor nach einem der Ansprüche 1 bis 9, der in jedem Pixel (1) ein Transfergate (TG) aufweist, das die wenigstens eine Fotodiode mit dem ersten Transistor (T1) koppelt.

11. Sensor nach einem der Ansprüche 1 bis 10, wobei der erste Transistor (T1) als Source-Folger geschaltet ist, der zweite Transistor (T2) als Source-Folger geschaltet ist und der dritte Transistor (T3) als gemeinsame Source geschaltet ist.

12. Sensor nach einem der Ansprüche 1 bis 11, wobei der Verbindungsknoten (114) der zweiten Stromquelle (108) mit dem dritten MOS-Transistor (T3) ausgebildet ist zum Bereitstellen eines Signals (OUT), das ein Ergebnis eines Vergleichs einer Spannung am Gate des ersten Transistors (T1) mit der Vergleichsspannung (Vcmp) anzeigt.

13. Sensor nach einem der Ansprüche 1 bis 12, wobei für wenigstens zwei Pixel (1) des Sensors ein einzelner zweiter Transistor (T2), eine einzelne erste Stromquelle (104), ein einzelner dritter Transistor (T3) und eine einzelne zweite Stromquelle (108) jeweils die zweiten Transistoren (T2), die ersten Stromquellen (104), die dritten Transistoren (T3) und die zweiten Stromquellen (108) der wenigstens zwei Pixel realisieren.

## Claims

1. Light sensor (4) comprising a plurality of pixels (1), each pixels comprising:
a first MOS transistor (T1) with a first type of channel and a second MOS transistor (T2) with a second type of channel, the first and second transistors (T1, T2) being series-connected and having their sources (S) connected, a gate of the second transistor (T2) being configured to receive a comparative voltage (Vcmp);
a first current source (104) series-connected with the first and second transistors (T1, T2) between a first node (100) configured to receive a first supply voltage (GND) and a second node (102) configured to receive a second supply voltage (VDD2);
a third MOS transistor (T3) and a second current source (108) series-connected between a third node (110) configured to receive a third supply voltage (GND) and a fourth node (112) configured to receive a fourth supply voltage (VDD1), the third transistor (T3) having a gate connected to a fifth node (106) of connection of the first current source (104) with the first and second transistors (T1, T2) in series and having a channel of the same type as the one of the first transistor (T1);
at least one photodiode (PD) coupled to a gate of the first transistor (T1); and
a reset switch (RST) having a conduction terminal connected to the gate of the first transistor (T1).

2. Sensor according to claim 1, wherein another conduction terminal of the reset switch (RST) is connected to the connecting node (114) of the second current source (108) to the third transistor (T3).

3. Sensor according to claim 1 or 2, wherein the sensor (4) also comprises, for each third transistor (T3), a shaping circuit (116) having an input coupled to the connecting node (114) of the second current source (108) to the third transistor (T3).

4. Sensor according to any one of claims 1 to 3, wherein:
said at least one photodiode (PD) belongs to a semiconductor substrate (L1); and
the first, second, third transistors (T1, T2, T3), the first and second current sources (104, 108) and the switch (RST) belong to a semiconductor layer (L3) lying on an insulating layer (300) that lies on said semiconductor substrate (L1).

5. Sensor according to claim 4 in its dependency to claim 3, wherein:
a first interconnecting structure (BEOL1) lies on the semiconductor layer (L3);
the shaping circuit (116) belongs to another semiconductor layer (L2) or to another semiconductor substrate (L2);
a second interconnecting structure (BEOL2) lies on said other semiconductor layer (L2) or said other semiconductor substrate (L2); and
a set comprising the substrate (L1), the isolating layer (300), the semiconductor layer (L3) and the first interconnection structure (BEOL1) is mounted on a set comprising the second interconnection structure (BEOL2) and said other semiconductor layer (L2) or said other semiconductor substrate (L2), by hybrid bonding of the first interconnection structure (BEOL1) to the second interconnection structure (BEOL2).

6. Sensor according to any one of claims 1 to 5, wherein the sensor (4) further comprises a circuit configured to provide said comparative voltage (Vcmp).

7. Sensor according to claim 6, wherein said comparative voltage (Vcmp) comprises voltage ramps.

8. Sensor according to any one of claims 1 to 7, wherein the first and third supply voltages are equal and correspond to the ground.

9. Sensor according to claim 8, wherein the second and fourth supply voltages are positive relative to the ground, the first transistor (T1) has a P-type channel, the second transistor (T2) has a N-type channel, the first current source (104) is connected to the second node (102) and the second current source (108) is connected to the third node (110).

10. Sensor according to any one of claims 1 to 9, comprising, in each pixel (1), a transfer gate (TG) that couples said at least one photodiode to the first transistor (T1).

11. Sensor according to any one of claims 1 to 10, wherein the first transistor (T1) is mounted as a source follower, the second transistor (T2) is mounted as a source follower and the third transistor (T3) is mounted as a common source.

12. Sensor according to any one of claims 1 to 11, wherein the connection node (114) of the second current source (108) to the third MOS transistor (T3) is adapted to provide a signal (OUT) indicating a result of a comparison of a voltage on the gate of the first transistor (T1) to the comparative voltage (Vcmp).

13. Sensor according to any one of claims 1 to 12 wherein, for at least two pixels (1) of the sensor, a single second transistor (T2), a single first current source (104), a single third transistor (T3) and a single second current source (108) implement respectively the second transistors (T2), the first current sources (104), the third transistors (T3) and the second current sources (108) of said at least two pixels.
